# EUROPEAN PATENT APPLICATION

(11) **EP 1 622 439 A2**
(43) Date of publication of application: **01.02.2006**
(21) Application number: 05254589.4
(22) Date of filing: 22.07.2005
(51) Int. Cl.: H05K 5/02

(54) **Door opening and closing device and electronic apparatus having the same**

(30) Priority: 29.07.2004 KR 2004059838
(71) Applicant: Samsung Electronics Co., Ltd., Yeongtong-gu Suwon-si, Gyeonggi-do (KR)
(72) Inventor: Oh, Gue-sik, Banwol-ri, Taean-eup Hwaseong, Gyeonggi (KR)
(74) Representative: Jackson, Nicholas Andrew

(57) **Abstract**

A door opening and closing device (114) and an electronic apparatus (100), which can reduce the size of a door (110) of the electronic apparatus (100). The door opening and closing device (114) includes at least one locking surface portion (115) formed at a door (110) of a front panel (102), and at least one locking support portion (120) disposed horizontally to either an upper portion or a lower portion of the component on the front panel (102), for resiliently pressing the locking surface portion (115), to thereby keep the door (110) in an opened position or closed position. A transverse width (D) of a door (110) can be reduced to a range of the transverse width of components, which are intended to be covered by the door (110), such as the memory card opening, the connecting jack portion (108), and the control button portion (105). Thus, material and manufacturing costs can be reduced, and the degree of freedom in design of the door can be increased.

## Description

The present invention relates to an electronic apparatus, such as a video tape recorder (VTR), a CD-ROM drive, a video disc apparatus, a digital audio disc apparatus, a digital video disc (DVD) player and a DVD player having a VTR function, and more particularly, to a door opening and closing device for opening or closing a door of the electronic apparatus, and an electronic apparatus having the same.

Generally, in an electronic apparatus, for example, a DVD player that records or reproduces information on a disc or a cassette, a front door for closing a doorway which allows entrance and exit of a disk or a cassette, and doors for covering openings of an audio/video (A/V) connecting jack, a control button, or a memory card are provided on a front panel of the electronic apparatus.

These doors prevent impurities such as dust from entering the openings of the A/V connecting jack, the control button and the memory card, to thereby improve the quality of appearance.

Further, the doors for covering the openings of the A/V connect jack, the control button and the memory card have door opening and closing devices which keep the doors stationary at their opened or closed positions after the doors are opened or closed.

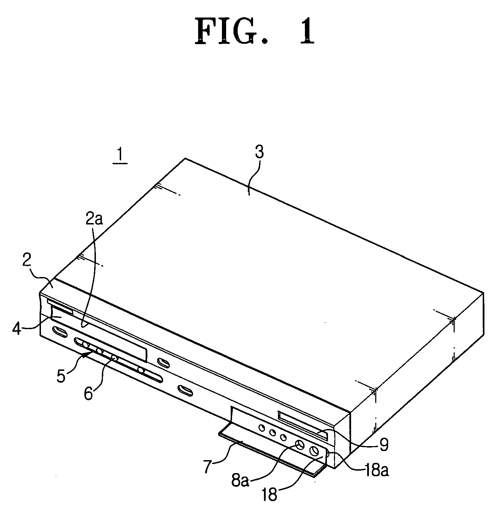

Figure 1 illustrates a conventional electronic apparatus 1 including a door for covering the opening of an A/V connecting jack having a door opening and closing device.

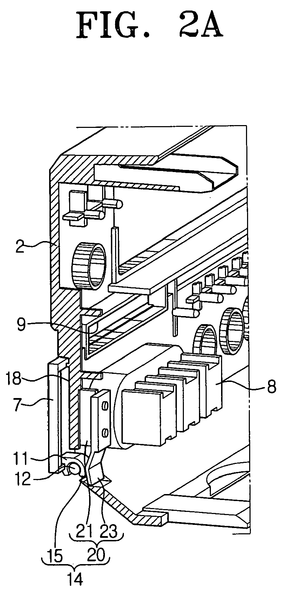

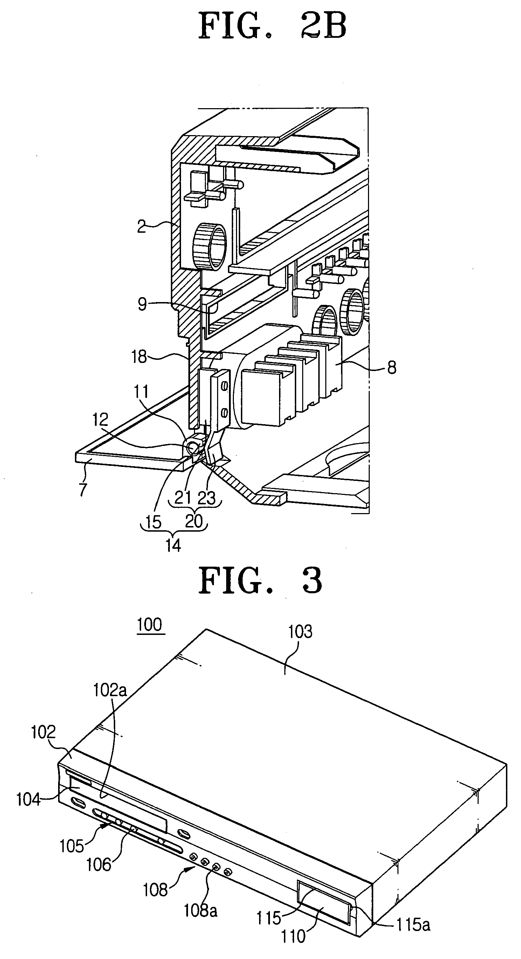

The electronic apparatus 1 includes a front panel 2 and a main body 3. The front panel 2 includes a front door 4, a control button portion 5, a memory card opening 9, and a connecting jack door 7. The front door 4 includes a doorway 2a disposed at an upper portion of the front door 4 on one side thereof, to allow entrance and exit of a disc tray (not shown) mounted with a disc (not shown) or a cassette (not shown). The control button portion 5 is disposed below the front door 4 and includes a plurality of control buttons 6. A memory card opening 9 is disposed at an upper portion of the front door 2 on its other side and is aligned with a slot of the memory card device (not shown) provided in a main body 3 so that a memory card (not shown) for storing information is inserted into or taken out from the slot of the memory card device. The connecting jack door 7 is rotatably provided in a recessed portion 18 which is formed on the front face of the front panel 2 below the memory card opening 9, and covers A/V connecting jacks 8a protruded toward the recessed portion 18 of the front face of the front panel 2 at a connecting jack portion 8 (see Figures 2A and 2B) provided on the backside of the front panel 2 and which are connected to an external apparatus (not shown).

In Figures 2A and 2B, the connecting jack door 7 is supported so as to rotate about first and second hinge shafts 12 (only one is shown for illustration purposes), which are formed on the front panel 2, by first and second hinged parts 11 (only one is shown for illustration purposes) protruded at both lower portions of the connecting jack door 7.

Further, the connecting jack door 7 includes a door opening and closing device 14 which keeps the connecting jack door 7 stationary in a closed position (see Figure 2A) and an opened position (see Figure 2B).

The door opening and closing device 14 includes a locking surface portion 15 formed on the hinged part 11, and a locking support portion 20 vertically provided on the backside of the front panel 2 for resiliently pressing the locking surface portion 15.

The locking support portion 20 includes a supporting bracket 21 vertically formed adjacent to one side of the connecting jack portion 8 on the backside of the front panel 2, and an elastic piece 23 protrudingly supported toward the locking surface portion 15 by the supporting bracket 21.

The operation of opening or closing the connecting jack door 7 constructed as above will now be described below.

In Figure 2A, when the connecting jack door 7 is closed, the locking surface portion 15 of the door opening and closing device 14 is pressed by the own elasticity of the elastic piece 23, abutting on the elastic piece 23 of the locking support portion 20. Thus, the connecting jack door 7 is kept in a closed position without moving into a recessed portion 18 of the front panel 2.

In this state, when a user pulls one side of the connecting jack door 7 disposed adjacent to a guide recess 18a (see Figure 1) formed on one side of the recessed portion 18 in order to open the connecting jack door 7, the connecting jack door 7 rotates about the first and second hinge shafts 12 in the counterclockwise direction. Consequently, the locking surface portions 15 formed on the first and second hinged parts 11 are rotated while pressing the elastic piece 23.

When the connecting jack door 7 is completely opened in this way, the locking surface portion 15 is pressed while abutting on the elastic piece 23. Thus, the connecting jack door 7 is kept closed.

Thereafter, the connecting jack portion 8 is connected to the external apparatus. Then, when a user lifts the connecting jack door 7 toward the recessed portion 18 of the control panel 2, while holding one side of the connecting jack door 7 in order to close the connecting jack door 7, the connecting jack door 7 rotates about the first and second hinge shafts 12 in the clockwise direction. As a result, the locking surface portion 15 rotates while pressing the elastic piece 23, whereby the connecting jack door 7 is closed as shown in Figure 2A.

However, in the conventional electronic apparatus 1 constructed as above, since the locking support portion 20 of the door opening and closing device 14 includes a structure which is disposed vertically on the backside of the front panel 2, the locking support portion 20 is installed beyond the range of the transverse width of the connecting jack portion 8 provided on the backside of the front panel 2, that is, on one side of the connecting jack door 7. Therefore, the connecting jack door 7 having the door opening and closing device 14 should be designed to have a width large enough to cover the transverse width of the locking support portion 20, and therefore, larger than the transverse width of the connecting jack portion 8 to be covered. Thus, the material cost of the connecting jack door 7 increases inevitably, which may result in an increase in the manufacturing cost.

Further, since the connecting jack door 7 cannot be designed to have a smaller transverse width than the connecting jack portion 8, the design of the connecting jack door 7 is very limited.

In particular, in the case of covering a small structure or component like the memory card opening 9, a memory card door (not shown) having a door opening and closing device has a larger transverse width than the transverse width of a memory card device by the transverse width of the locking support portion 20 due to the restrictions in design as described above. Therefore, the memory card door has a much larger transverse width than the memory card opening 9. As a result, the appearance quality of an electronic apparatus deteriorates.

Accordingly, the conventional electronic apparatus 1, as shown in Figure 1, does not include a memory card door for covering the memory card opening 9. Therefore, without the memory card door, foreign substance such as dust may easily flow into the memory card device through the memory card opening 9. As a result, a problem may occur in that the memory card device is damaged, or the lifespan thereof is shortened.

According to the present invention there is provided an apparatus and method as set forth in the appended claims. Preferred features of the invention will be apparent from the dependent claims, and the description which follows.

Accordingly, it is an aim of the present invention to provide a door opening and closing device which allows the transverse width of a door to be reduced to a range of the transverse width of components, which are intended to be covered, and an electronic apparatus comprising the same.

Additional aspects and/or advantages of the invention will be set forth in part in the description which follows and, in part, will be apparent from the description, or may be learned by practice of the invention.

In accordance with one aspect of the present invention there is provided a door opening and closing device of an electronic apparatus having at least one door rotatably provided on a front panel for covering a component formed on the front panel. The door opening and closing device may include at least one locking surface portion formed at the door, and at least one locking support portion disposed horizontally to either an upper portion or a lower portion of the component on the front panel adjacent to thereto, the locking support portion resiliently pressing the locking surface portion to thereby keep the door in an opened position or a closed position.

The locking support portion may include a supporting bracket formed horizontally to the component, and an elastic piece supported horizontally to the supporting bracket. The elastic piece may include a contact surface which contacts with the locking surface portion.

The locking surface portion may be formed at a hinged part for rotatably supporting the door with respect to the front panel, and includes a parallel surface formed parallel to the door and a vertical surface formed vertically to the door.

The component may include at least one of an entrance opening portion having at least one opening which allows entrance and exit of at least one of a disc tray mounted with a disc and a cassette, a connecting jack portion having at least one jack connected to an external apparatus, a control button portion having at least one control button for controlling the electronic apparatus, or a memory card opening portion having an opening which allows entrance and exit of a memory card.

In accordance with another aspect of the present invention there is provided an electronic apparatus including a front panel having a component and at least one door for covering the component, the component including at least one of an entrance opening portion disposed on the front panel having at least one opening which allows entrance and exit of at least one of a disc tray mounted with a disc and a cassette, a connecting jack portion having at least one jack connected to an external apparatus, a control button portion having at least one control button for controlling the electronic apparatus, and a memory card opening portion having an opening which allows entrance and exit of a memory card. The electronic apparatus may further include a door opening and closing device having at least one locking surface portion formed on the door, and at least one locking support portion disposed on the front panel for resiliently pressing the locking surface portion, to thereby keep the door in an opened position or a closed position. The locking support portion may be disposed horizontally to either an upper portion or a lower portion of the component adjacent thereto.

The locking support portion may include a supporting bracket formed horizontally to the component, and an elastic piece supported horizontally to the supporting bracket. The elastic piece may include a contact surface which contacts with the locking surface portion.

The locking surface portion may be formed at a hinged part for rotatably supporting the door with respect to the front panel, and includes a parallel surface formed parallel to the door and a vertical surface formed vertically to the door.

These and/or other aspects and advantages of the invention will become apparent and more readily appreciated from the following description of the embodiments, taken in conjunction with the accompanying drawings of which:
Figure 1 is a perspective view of a conventional electronic apparatus;
Figures 2A and 2B are fragmentary cutaway perspective views illustrating the operation of a connecting jack door of the conventional electronic apparatus shown in Figure 1;
Figure 3 is a perspective view of the electronic apparatus having a memory card door and a door opening and closing device according to an embodiment of the present invention;
Figure 4 is a fragmentary exploded perspective view of a locking support part of the door opening and closing device for the memory card door of the electronic apparatus shown in Figure 3;
Figure 5A, 5B and 5C are fragmentary cutaway perspective views illustrating the operation of the memory card door of the electronic apparatus shown in Figure 3; and
Figure 6 is a fragmentary cutaway perspective view illustrating the relationship between the transverse width of the memory card door and the transverse width of a memory card opening shown in Figure 4.

Reference will now be made in detail to embodiments of the present invention, examples of which are illustrated in the accompanying drawings, wherein like reference numerals refer to the like elements throughout. Preferred embodiments are described below to explain the present invention by referring to the figures.

The matters defined in the description such as a detailed construction and elements are provided to assist in a comprehensive understanding of the invention. Thus, it is apparent that the present invention can be carried out without those defined matters. Also, well-known functions or constructions are not described in detail since they would obscure the invention in unnecessary detail.

Figure 3 illustrates an electronic apparatus 100 having a door opening and closing device according to an embodiment of the present invention.

The electronic apparatus 100 comprises a front panel 102 and a main body 103.

The front panel 102 comprises a front door 104, a control button portion 105, a connecting jack portion 108, and a memory card door 110.

The front door 104 is disposed on an upper portion of the front panel 102 at its one side, and is supported so as to be resiliently rotatable about first and second support shafts (not shown) formed at both ends thereof with respect to a supporting bracket (not shown) which is formed on the backside of the front panel 102. Thus, when a disc tray (not shown) mounted with a disc (not shown) or a cassette (not shown) is taken out of the main body 103, the front door 104 opens its entrance opening 102a, whereas when the disc tray or cassette is inserted into the main body 103, the front door 104 closes its entrance opening 102a to prevent the interior of the main body 103 from being exposed to the outside. The construction and operation of this front door 104 is generally known, and thus the detailed description thereof will be omitted.

The control button portion 105 is disposed below the front door 104, and comprises a plurality of control buttons 106.

The connecting jack portion 108 is disposed at the center of the front panel 102 adjacent to the control button portion 105, and comprises A/V connecting jacks 108a which protrude forward from the front panel 102 and which are connected to the external apparatus. Here, Figure 3 illustrates the A/V connecting jacks 108a not covered by a connecting jack door. However, as an alternative, the A/V connecting jacks 108a may be configured to be covered by the connecting jack door 7 as in the conventional electronic apparatus 1 shown in Figure 1.

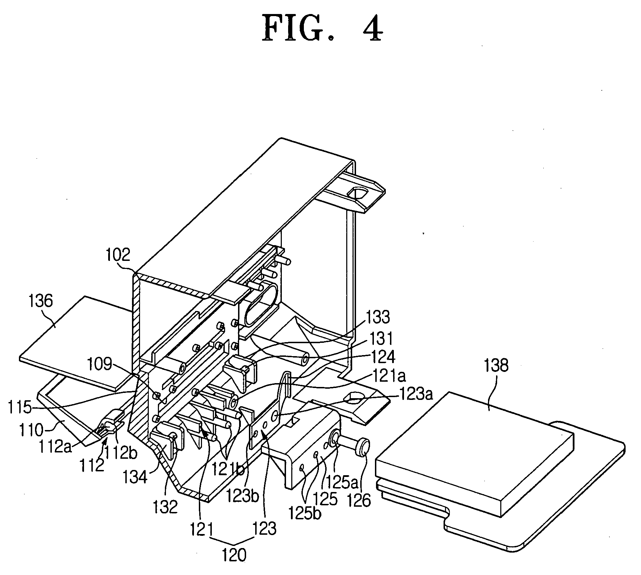

The memory card door 110 is provided in a recessed portion 115 which is formed on the front face of the front panel 102 at its other side, to cover a memory card opening 109 (see Figure 4). The memory card opening 109 is aligned with a slot (not shown) of the memory card device 138 mounted on the main body 103 so that a memory card 136 is inserted into or taken out of the slot of the memory card device 138. The memory card device 138 enables reproducing of information stored in the memory card 136 of a digital camera or a computer, or enables restoring of information reproduced in a disc or a cassette to the memory card 136 and reproducing or editing information in the digital camera or the computer.

As shown in Figures 4 to 6, the memory card door 110 is supported so as to be rotatable about first and second hinge shafts 131 and 132 by first and second hinged parts 111 and 112 which are protruded at both lower portions of the memory card door 110.

The first and second hinged parts 111 and 112 have first and second openings 111a and 112a, respectively, which can accommodate the first and second hinge shafts 131 and 132 in assembling. Inlets of the first and second openings 111a and 112a are respectively formed with first and second hooks 111b and 112b which prevents the first and second hinge shafts 131 and 132 from being separated from the openings 111a and 112a.

The first and second hinge shafts 131 and 132 are supported by the first and second hinge brackets 133 and 134 which are formed with a predetermined distance to face the first and second hinged parts 111 and 112 on the backside of the front panel 102.

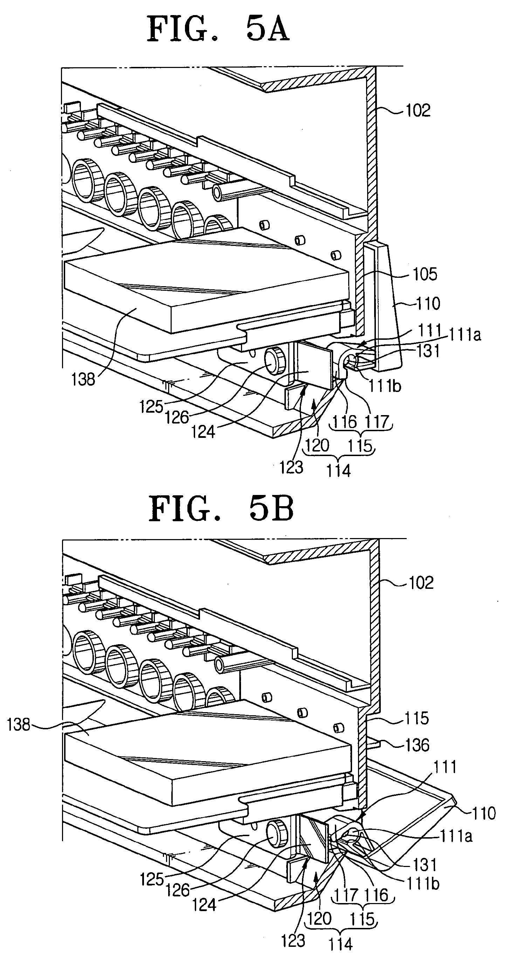

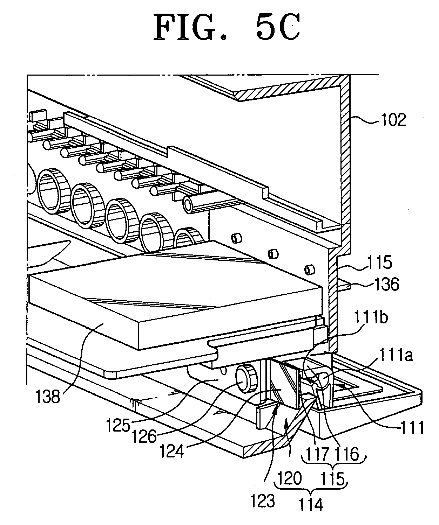

Further, the memory card door 110 comprises a door opening and closing device 114 which keeps the memory card door 110 stationary in an opened position (see Figure 5A) and a closed position (see Figure 5B).

In Figure 5A to 5C, the door opening and closing device 114 comprises a locking surface portion 115 and a locking support portion 120.

The locking surface portion 115 comprises a parallel surface 116 and a vertical surface 117 formed on the first hinged part 111. The parallel surface 116 is substantially formed parallel to the memory card door 110 at the bottom of the first hinged part 111, and the vertical surface 117 is formed substantially vertically to the memory card door 110 adjacent to the parallel surface 116.

In Figure 4, the locking support portion 120 comprises a supporting bracket 121 formed horizontally to the backside of the front panel 102 below the memory card device 138 provided in the main body 103, and an elastic piece 123 fixed horizontally to the supporting bracket 121 by means of a fixing piece 125. The fixing piece 125 attaches the elastic piece 123 to the supporting bracket 121 by means of a screw 126 and a fixing boss 121b of the supporting bracket 121. The screw 126 is tightened to a tightening boss 121a of the supporting bracket 121 through tightening holes 125a and 123a of the fixing piece 125 and the elastic piece 123, and the fixing boss 121b is engaged with fixing holes 125b and 123b of the fixing piece 125 and the elastic piece 123, respectively.

The elastic piece 123 comprises a contact surface 124 that protrudes toward the locking surface portion 115 and contacts with and presses the parallel surface 116 or the vertical surface 117 of the locking surface portion 115, depending on a rotational position of the memory card door 110.

Thus, as shown in Figure 5A, when the memory card door 110 is in a closed position, the elastic piece 123 contacts with and presses the parallel surface 116 of the locking surface portion 115, thereby keeping the memory card door 110 in a closed position, and as shown in Figure 5C, when the memory card door 110 is at an opened position, the elastic piece 123 contacts with and presses the vertical surface 117 of the locking surface portion 115, thereby keeping the memory card door 110 at an opened position.

In this embodiment of the present invention, the locking surface portion 115 and the locking support portion 120 of the door opening and closing device 114 are provided on only the first hinged part 111. However, as an alternative, the locking surface portion 115 and the locking support portion 120 may be provided on the second hinged part 112, or on both the first and second hinged parts 111 and 112.

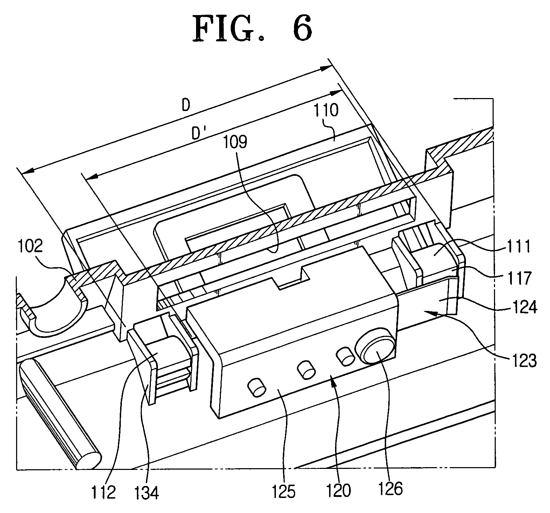

Figure 6 illustrates the relationship between the transverse width D of the memory card door 110 and the transverse width D' of the memory card opening 109.

In Figure 6, since the locking support portion 120 of the door opening and closing device 114 is provided horizontally to the backside of the front panel 102 below the memory card device 138 provided in the main body 103, the transverse width D of the memory card door 110 may be constructed to be equal to or smaller than the transverse width D' of the memory card opening 109 irrespective of the transverse width of the memory card device 138 by decreasing the transverse width of the locking support portion 120.

However, in the present invention, in order to improve the appearance quality in view of the transverse width of the memory card 136, the transverse width D of the memory card door 110 is formed to be slightly larger than the transverse width D' of the memory card opening 109.

In the electronic apparatus 100 exemplified and described above, only the memory card opening 109 is covered by the memory card door 110 having the door opening and closing device 114. It should be appreciated that the present invention is not limited thereto, and other structure may be employed, for example, the front door 104, the control button portion 105, or the connecting jack portion 108 (shown in Figure 3) may be covered by doors (not shown) having the door opening and closing device 114.

Further, in the electronic apparatus 100 of the present invention exemplified and described above, the first and second hinged parts 111 and 112, the first and second hinge shafts 131 and 132 and the door opening and closing device 114 of the memory card door 110 are provided below the memory card device 138, but depending on a design, they may be provided above the memory card device 138.

The operation of opening or closing the memory card door 110 of the electronic apparatus structured as above will now be described below.

In Figure 5A, when the memory card door 110 is closed, the parallel surface 116 of the locking surface portion 115 of the door opening and closing device 114 is pressed by the elasticity of the elastic piece 123 in a state that abuts on the contact surface 124 of the elastic piece 123 of the locking support portion 120. Thus, the memory card door 110 is kept at a closed position without moving into the recessed portion 115 of the front panel 102.

In this state, when a user pulls one side of the memory card door 110 exposed through a guide recess 115a (see Figure 3) formed on one side of the recessed portion 115 in order to open the memory card door 110, the memory card door 110 rotates about the first and second hinge shafts 131 and 132 in the counterclockwise direction (see Figure 4; clockwise direction in Figures 5A to 5C). Consequently, the parallel surface 116 formed on the first hinged part 111 is rotated while pushing the contact surface 124 of the elastic piece 123.

Thereafter, as shown in Figure 5B, when the memory card door 110 is opened until a corner between the parallel surface 116 and the vertical surface 117 of the first hinged portion 112 abuts on the contact surface 124 of the elastic piece 123, the memory card door 110 is automatically rotated to an opened position shown in Figure 5C, with a force of repulsion of the elastic piece 123.

When the memory card door 110 is completely opened in this way, the vertical surface 117 of the locking surface portion 115 is pressed while abutting on the contact surface 124 of the elastic piece 123. Thus, the memory card door 110 is kept open.

Thereafter, the memory card door 110 is inserted or taken out of the slot of the memory card device 138. Then, when a user lifts the memory card door 110 toward the recessed portion 115 of the control panel 102 while holding one side of the memory card door 110 in order to close the memory card door 110, the memory card door 110 rotates about the first and second hinge shafts 131 and 132 in the clockwise direction. As a result, the vertical surface 117 formed on the first hinged part 111 rotates while pressing the contact surface 124 of the elastic piece 123.

Thereafter, as shown in Figure 5B, when the memory card door 110 is closed until the corner between the parallel surface 116 and the vertical surface 117 of the hinged part 111 abuts on the contact surface 124 of the elastic piece 123, the memory card door 110 is automatically rotated to a closed position shown in Figure 5A, with a force of repulsion of the elastic piece 123.

When the memory card door 110 is completed closed in this way, the parallel surface 116 of the locking surface portion 115 is pressed while abutting on the contact surface 124 of the elastic piece 123. Thus, the memory card door 110 is kept closed.

As described above, the door opening and closing device according to an embodiment of the present invention and the electronic apparatus comprising the same allows the transverse width of a door to be reduced to a range of the transverse width of components, which are intended to be covered, such as the memory card opening, the connecting jack portion, and the control button portion, and thus allows the cost of material to be reduced, thereby not only reducing the manufacturing cost but also increasing the degree of freedom in design of the door.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A door opening and closing device (114) of an electronic apparatus (100) having at least one door (110) rotatably provided on a front panel (102) for covering a component formed on the front panel (102), comprising:
at least one locking surface portion (115) formed at the door (110); and
at least one locking support portion (120) disposed horizontally to either an upper portion or a lower portion of the component on the front panel (102) adjacent to thereto, the locking support portion (120) resiliently pressing the locking surface portion (115) to thereby keep the door (110) in an opened position or a closed position.

2. The door opening and closing device (114) of the electronic apparatus (100) as claimed in claim 1, wherein the locking support portion (120) comprises,
a supporting bracket (121) formed horizontally to the component; and
an elastic piece (123) supported horizontally to the supporting bracket (121).

3. The door opening and closing device (114) of the electronic apparatus (100) as claimed in claim 2, wherein the elastic piece (123) comprises a contact surface (124) which contacts with the locking surface portion (115).

4. The door opening and closing device (114) of the electronic apparatus (100) as claimed in claim 3, wherein the locking surface portion (115) is formed at a hinged part (111) for rotatably supporting the door (110) with respect to the front panel (102), and comprises a parallel surface (116) formed parallel to the door (102) and a vertical surface (117) formed vertically to the door (102).

5. The door opening and closing device (114) of the electronic apparatus (100) as claimed in any preceding claim, wherein the component comprises at least one of an entrance opening portion having at least one opening which allows entrance and exit of at least one of a disc tray mounted with a disc and a cassette, a connecting jack portion (108) having at least one jack connected to an external apparatus, a control button portion (105) having at least one control button for controlling the electronic apparatus, or a memory card opening portion having an opening (109) which allows entrance and exit of a memory card (136).

6. An electronic apparatus (100), comprising:
a front panel (102) having a component and at least one door (110) for covering the component, the component including at least one of an entrance opening portion having at least one opening which allows entrance and exit of at least one of a disc tray mounted with a disc and a cassette, a connecting jack portion (108) having at least one jack connected to an external apparatus, a control button portion (105) having at least one control button for controlling the electronic apparatus, and a memory card opening portion having an opening (109) which allows entrance and exit of a memory card (136); and
a door opening and closing device (114) having at least one locking surface portion (115) formed on the door (110), and at least one locking support portion (120) disposed on the front panel (102) for resiliently pressing the locking surface portion (115), to thereby keep the door (110) in an opened position or closed position, wherein the locking support portion (120) is disposed horizontally to either an upper portion or a lower portion of the component adjacent thereto.

7. The electronic apparatus (100) as claimed in claim 6, wherein the locking support portion (120) comprises,
a supporting bracket (121) formed horizontally to the component; and
an elastic piece (123) supported horizontally to the supporting bracket (121).

8. The electronic apparatus (100) as claimed in claim 7, wherein the elastic piece (123) includes a contact surface (124) which contacts with the locking surface portion (115).

9. The electronic apparatus (100) as claimed in any one of claim 6 to claim 8, wherein the locking surface portion (115) is formed at a hinged part (111) for rotatably supporting the door (110)with respect to the front panel (102), and comprises a parallel surface (116) formed parallel to the door (102) and a vertical surface (117) formed vertically to the door (110).

10. An electronic apparatus (100) having a door (110) rotatably provided on a front panel (102) thereof, to cover a component of the electronic apparatus (100), comprising:
an opening and closing device (114) to open and close the door (110), and comprising:
a locking surface portion (115) having a parallel surface portion (115) formed parallel to the door (110) and a vertical surface portion (117) formed vertically to the door (110), and
a locking support portion (120) having an elastic piece (123) for contacting with the parallel surface portion (116) and the vertical surface portion (117), wherein the elastic piece (123) contacts with the vertical surface portion (117) to keep the door (110) in an opened position, and the elastic piece (123) contacts with the parallel surface portion (116) to keep the door (110) in a closed position.

11. The electronic apparatus (100) of claim 10, wherein the elastic piece (123) comprises a contact surface (124) which protrudes toward the locking surface portion (115) and contacts with and presses the parallel surface portion (116) or the vertical surface portion (117) of the locking surface portion (115), depending on a rotational position of the door (110).

12. The electronic apparatus (100) of claim 10 or claim 11, wherein a transverse width (D) of the door (110) is equal to or smaller than a transverse width (D') of an opening (109) of the component of the electronic apparatus (100).

13. The electronic apparatus (100) as claimed in anyone of claim 10 to claim 12, wherein the locking support portion (120) is disposed horizontally to either an upper portion or a lower portion of the component adjacent thereto.

14. The electronic apparatus (100) as claimed in any one of claim 10 to claim 13, wherein the component comprises an opening for at least one of a disc tray mounted with a disc and a cassette, a connecting jack portion (108) to be connected with an external apparatus, a control button portion (105) or a memory card opening (109) for insertion of a memory card (136).
